Europäisches Patentamt

(19) European Patent Office

Office européen des brevets

(11) Publication number : **0 396 403 B1**

# (12) EUROPEAN PATENT SPECIFICATION

(45) Date of publication of patent specification :
31.05.95 Bulletin 95/22

(51) Int. Cl.⁶ : **H04L 7/04**

(21) Application number : **90304786.8**

(22) Date of filing : **02.05.90**

(54) Data stream frame synchronisation.

(30) Priority : **04.05.89 GB 8910255**

(43) Date of publication of application :
**07.11.90 Bulletin 90/45**

(45) Publication of the grant of the patent :
**31.05.95 Bulletin 95/22**

(84) Designated Contracting States :
**BE DE DK ES FR GB IT NL SE**

(56) References cited :
**US-A- 3 336 467
US-A- 3 466 601
IEEE TRANSACTIONS ON INFORMATION
THEORY, vol. 34, no. 4, July 1988, pages
752-775, IEEE, New York, US; R.M. TANNER:
"A transform theory for a class of group-
invariant codes"**

(56) References cited :
**ELECTRONICS LETTERS, vol. 19, no. 3, 3rd
February 1983, pages 109-110, London, GB;
S.R. ELY et al.: "High-speed decoding tech-
nique for slip detection in data transmission
systems using modified cyclic block codes"
IEEE TRANSACTIONS ON INFORMATION
THEORY, vol. JT-16, no. 2, March 1970, pages
238-241; S.E. TAVARES et al.: "Further results
on the synchronization of binary cyclic codes"
IEEE TRANSACTIONS ON INFORMATION
THEORY, vol. IT-16, no. 2, March 1970,
pages241-242; S.G.S. SHIVA et al.:
"Synchronizable error-correcting binary
codes"**

(73) Proprietor : **NORTHERN TELECOM LIMITED
World Trade Center of Montreal,
380 St. Antoine Street West, 8th Floor
Montreal, Quebec H2Y 3Y4 (CA)**

(72) Inventor : **Brueckheimer, Simon Daniel
204 Victoria Road
London N22 4XQ (GB)**

(74) Representative : **Ryan, John Peter William et al
Nortel Limited
Patents and Licensing
West Road
Harlow, Essex CM20 2SH (GB)**

## Description

This invention relates to data stream frame synchronisation detection and apparatus therefor.

A method of detecting frame synchronisation of a data stream is described by R M Tanner in IEEE Transition on Information Theory, 34 (1988) July No. 4, pp 752-775. This document describes a technique of using check digits for synchronisation of frames of fixed length and having a header at a predetermined position in each frame.

According to one aspect of the present invention there is provided a method of detecting frame synchronisation of a data stream, which frames are of fixed length or of a variable but determinable length indicated by a pattern or by information in the data stream, which frames include a fixed length header at a predetermined position in each frame, which header has a linear systematic code structure including information symbols and check symbols, which check symbols are derived from a polynomial representative of the information symbols of the header, which polynomial has coefficients valid over a Galois field, by their polynomial division by a code generator polynomial whose coefficients are defined over a Galois field, and wherein the check symbols are employed for frame synchronisation detection without compromising their responsible use for error detection in and correction of the header, characterised in that the method of detection comprises the steps of dividing an incoming data stream by the code generator polynomial, simulatneously dividing a preceding but delayed incoming data stream by the code generator polynomial, comparing any remainder of the first mentioned division with any remainder of the second mentioned simultaneous division, the presence of identical remainders indicating that the incoming data stream is a valid code word, and determining the occurrence of a succession of valid code words once every frame length for a predetermined number of frames, which occurrence indicates frame synchronisation.

According to another aspect of the present invention there is provided an apparatus for detecting frame synchronisation of a data stream, which frames are of fixed length or of a variable but determined length indicated by a pattern or by information in the data stream, which frames include a fixed length header at a predetermined position in each frame, which header has a linear systematic code structure including information digits and check digits, which check digits were derived from a polynomial representative of the information digits of the header, which polynomial has coefficients valid over a Galois field, by their polynomial division by a code generator polynomial whose coefficients are defined over a Galois field, the apparatus including means whereby a first incoming code word is divided by the code generator polynomial, means whereby a subsequent incoming code word is divided by the code generator polynomial, means whereby any remainder of the first division is compared with any remainder of the subsequent division, the presence of a predetermined relationship therebetween indicating that the subsequent incoming code word is valid, and means for correlating and indicating frame synchronisation in response to receipt of a succession of valid code words once every predetermined frame length for a predetermined number of frames.

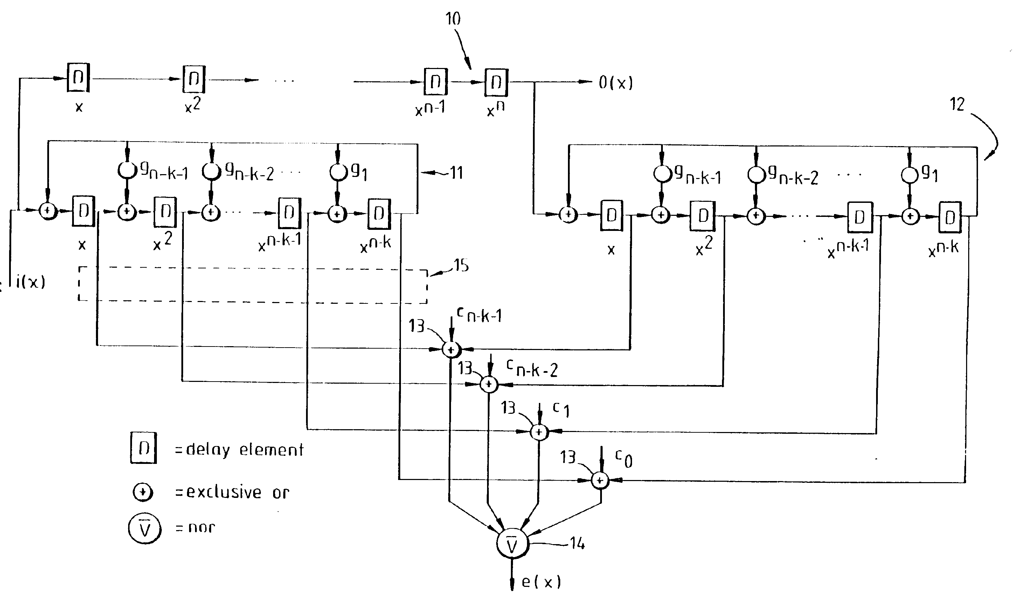

Embodiments of the invention will now be described with reference to the accompanying drawing which illustrates schematically a modified CRC decoder.

The data streams with which the invention is concerned have data structured into fixed length frames or arbitrary sized frames, when there is some indication of the current frame length - either predetermined, or derived from the data stream. The frames include a fixed length header at a predefined position in the frame. The header has a linear systematic code structure.

Thus, formally, for example, a particular binary data stream may be considered to have the following structure:-

(1) At the topmost level, the binary data form a frame of fixed length in bits L, and occurs every period of L bits, i.e. frames transmitted on the data bit stream are contiguous.

(2) The frame comprises a header and a body portion, the header being of length in bits n, where $n \leq L$, and the body being of length in bits j, where $j \leq L-n$.

(3) The header begins at an arbitrary, but fixed, offset in bits u, from the frame boundary, where $0 \leq u \leq L-n$.

(4) The header is a linear systematic code, i.e. the first k bits comprises the information, the latter r= n-k bits being the parity check bits, forming an (n, k) code structure. The parity check bits encode the information bits into the linear systematic code, and protect the header bits of the frame alone against error.

(5) The r parity check bits provide the ability to detect and possibly correct additive errors in the channel on which the binary data stream has been transmitted.

Since the header is at a fixed position in the frame, it will also have a periodicity of L. If n=L, the header is of the same length as the frame, and headers appear contiguously on the binary data stream. If n<L, then there are L-n arbitrary bits of a frame body between successive headers.

It is proposed that the linear systematic code parity check bits be used for the purpose of frame synchronisation at the receiver by virtue of their mathematical relationship with the information bits of the header. This facility is at no detriment to the additive error detection and correction capabilities of the code, and the choice of linear systematic code is only slightly restricted, by using it for this additional feature unless shortened cyclic codes are used, in which case a linear operator is required.

The applicable set of linear systematic codes are those whose parity check bits are derived from the polynomial representation of the k information bits by their division by a code generator polynomial $g(x)$. For example, this applies to cyclic codes and Bose Chaudhuri Hocquenghem codes. The conventional hardware mechanism that performs polynomial division is a clocked shift register with feedback applied to correspond to coefficients of the terms in the generator polynomial $g(x)$. By adapting the decoding mechanism it is possible to devise decoder hardware to perform the necessary frame synchronisation. Once frame synchronisation is obtained the decoder may assume its conventional role of error detection and correction, as well as now indicating possible synchronisation loss.

A conventional CRC (cyclic redundancy check) decoder can be realised by a shift register and linear feedback obtained via exclusive-or operations (modulo 2 summation). Such a decoder performs division of the incoming code word $i(x)$ by the code generator polynomial $g(x)$. The register is preset to all zero and the shift register contents are shifted by one position for each incoming bit of the code word. After n such shifts a remainder of zero indicates a valid code word and the absence of all error.

In a decoder configuration where the code word is fed into the shift register from the left, normally the shift register must be reset to all zero before the remainder calculation is performed. If it is not reset, it contains a remainder corresponding to having divided the code word of interest and the bits preceding the code word, the old contents of the register, by the generator polynomial. It can be shown mathematically that if the next n bits form a valid code word with the generator polynomial as its factor, then after their division an identical remainder will remain in the shift register to that contained prior to the shift operation. Since the code word is completely divisable by the generator polynomial, there has been no additive effect on the original remainder after shifting in the code word. By comparing the remainders just prior to and just after shifting in any n bit sequence, if these remainders are equal then the n bits form a valid code word. The true remainder of an errored code word can be obtained by the modulo 2 sum of these remainders, thus allowing normal error detection and possible further correction as well as frame synchronisation. There now follows a mathematical proof that there is no effect on the ability of a linear systematic code decoder circuit to detect valid or errored code words, if it has not been reset prior to this operation.

Let $i(x)$ be any valid code word of the linear systematic code.

Let $g(x)$ be the generator polynomial for that code.

At the encoder, $d(x)$ is the polynomial representation of the data sequence of k information bits, that is made into a code words $i(x)$ of length n, such that,

$$i(x) = x^{n-k}d(x) \oplus r(x)$$

where,

$$x^{n-k}d(x) = q(x)g(x) \oplus r(x)$$

and $d(x)$ is of degree k-1 or less, $r(x)$, the remainder, is of degree n-k-1 or less, and $i(x)$ is of degree n-1 or less.

Polynomial $g(x)$ must be chosen to be a factor or primitive polynomial of the polynomial expression $x^n \oplus 1$. This will guarantee a Hamming distance greater than 2, and ensures optimum error performance from the code. Therefore,

$$x^n \oplus 1 = h(x)g(x),$$

where $h(x)$ is the parity check polynomial for the code, of degree k. For $g(x)$ to be a primitive polynomial of $x^n \oplus 1$,

$$\sim \exists m : x^m \oplus 1 = f(x)g(x), \forall\, m < n$$

In the case of a valid code word and assuming the decoder contains some residual remainder polynomial $s(x)$ at an arbitrary moment in time, such that $i(x)$ is the next data sequence to be shifted in, then the remainder $s(x)$ is equivalent to an additive polynomial shifted by n places, or multiplied by $x^n$, i.e.

$$i'(x) = x^n s(x) \oplus i(x)$$

is the newly formed code word on which the decoder will operate. The division process yields the following result,

$$i'(x) = x^n s(x) \oplus i(x)$$
$$= x^n s(x) \oplus q(x)g(x)$$

where $q(x)$ is some quotient of degree k-1 or less,

$$= (x^n \oplus 1)s(x) \oplus s(x) \oplus q(x)g(x)$$

due to using modulo 2 addition,

$$= [h(x)s(x) \oplus q(x)]g(x) \oplus s(x)$$

where $s(x)$ is of degree n-k-1 or less,

$$= q'(x)g(x) \oplus s(x)$$

where $q'(x)$ is of degree $n-1$ or less and $s(x)$ is the original remainder. Remainder $s(x)$ will be the result left in the decoder register, which has been unchanged by having shifted in a valid code word $i(x)$.

In the case of a residual remainder and an errored code word, let $e(x)$ be some additive error polynomial introduced into the channel, such that,

$$i'(x) = i(x) \oplus e(x)$$

Ordinarily at the decoder,

$$i'(x) = q(x)g(x) \oplus e_q(x)g(x) \oplus e_r(x)$$
$$= q'(x)g(x) \oplus e_r(x)$$

where $q'(x) = q(x) \oplus e_q(x)$, the quotient part of the errored code word of degree k-1 or less, and $e_r(x)$ is the remainder, of degree n-k-1 or less.

Again assume some remainder $s(x)$ is in the decoder register just as $i'(x)$, the errored code word, is the data sequence about to be shifted in. As before,

$$i''(x) = x^n s(x) \oplus i'(x)$$

Dividing by the generator polynomial, g(x),

$$i'(x) = x^n s(x) \oplus q'(x)g(x) \oplus e_r(x)$$
$$= (x^n \oplus 1)s(x) \oplus s(x) \oplus q'(x)g(x) \oplus e_r(x)$$
$$= [h(x)s(x) \oplus q'(x)]g(x) \oplus s(x) \oplus e_r(x)$$
$$= q''(x)g(x) \oplus s'(x)$$

where,

$$s'(x) = s(x) \oplus e_r(x)$$

the new remainder of degree n-k-1 or less. Thus the syndrome $e_r(x)$ of the errored code word may be retrieved by summing the old and new remainders,

$$e_r(x) = s(x) + s'(x)$$

and in the presence of a detectable error, $e_r(x) \neq 0$.

Since $e_r(x) = 0$, in the absence of all error, or for an undetectable additive error, synchronisation of the decoder with the incoming valid code words, may be achieved by continually performing the above summation.

The probability that an arbitrary data sequence is a valid code word when using in an (n,k) linear systematic code, is $2^{-r}$, where r= n-k, since there are $2^k$ valid code words in $2^n$ possibilities. For modest r, this probably is small.

An example of a hardware mechanism that performs the function of continuously monitoring the incoming binary data stream for valid code words is shown in the accompanying drawing. It can be regarded as a modified CRC decoder.

In the initial condition, all delay elements D are reset to contain zero, although in theory only those delay elements that comprise the feedback loops need to be reset to the same value, i.e. the same remainder. The binary data stream i(x) enters at the left. The point o(x) is the same information stream as i(x), but delayed by n bit periods. The point e(x) is a binary data stream that contains a binary 1 digit whenever a valid code word in stream i(x) has been detected; the first bit of the valid code word is available in delay element $x^n$.

The circuit comprises two decoders 11, 12, one (11) operating on the i(x) stream and the other (12) on the o(x) stream. The decoders continuously divide the incoming data by the code's generator polynomial. The circles labelled $g_i$, $(1 \leq i \leq n-k-1)$ are the coefficients of the generator polynomial g(x), being either a 1, corresponding to a connection, or O, an open circuit. The second decoder 12 receives the incoming data delayed by n bit periods by delay line 10 and faithfully reproduces the remainders of the first decoder 11 for each bit shifted in. All delay elements are clock synchronously.

The contents of the two decoders are compared at each bit shift by an r bit wide comparator formed by separate exclusive-or elements 13 and a multi-input logical nor function 14.

The binary data stream e(x) is used to perform the frame synchronisation. There is a $2^{-r}$ chance that an arbitrary bit sequence of i(x) will form a valid code word. Thus e(x) may be 1 at times other than the detection of a frame header. (This is no different to data imitating a frame synchronisation sequence in a conventional approach). A valid 1 in the e(x) stream is defined to be repeated every L bits i.e. once every frame length.

Any method of frame synchronisation applicable to the detection of conventional frame synchronisation patterns may be used. Those skilled in the art will appreciate that any frame correlation technique for fixed or variable frame lengths may be employed on the output stream e(x) for determining frame synchronisation. Specifically, the output e(x) can be applied to a reset counter and comparator (not shown) to detect occurrences of valid code words every L bits. These correspond to the frame header. Spurious outputs are filtered by the counter not containing "L" when the next valid code word is detected. If the occurrences every L bits are repeated for some predefined number (m) of successive frames, synchronisation is achieved. If not periodic, the occurrence is a spurious output and a new position is searched by awaiting the next occurrence of a valid code word. Once header synchronisation is achieved, the frame start is at an offset u from this point.

A problem that occurs with cyclic codes is synchronisation resolution. Any cyclic shift of a cyclic code word is another valid code word. When just one bit period out of the true synchronisation position, there is a 50% probability (in the ideal case) that the missing bit will be imitated correctly by a bit adjacent to the header code word. However, by using a coset of the cyclic code, which does not contain the all zero code word, this resolution problem can be virtually eliminated.

In the transmitter encoder, the coset is formed by adding a known non-zero polynomial c(x) to the transmitted code, i.e. to all valid code words before transmission. The added polynomial results in an error in the detector when a cyclic shift of the code word is decoded, reducing the probability of code word imitation by adjacent bits.

The polynomial c(x) can always be arranged to be of degree n-k-1 or less. Using a similar analysis to before and since c(x) is indivisable by the generator polynomial g(x), the final result at the decoder will be,

$$i_c'(x) = q''(x)g(x) \oplus s'(x) \oplus e_r(x) \oplus c(x)$$
$$= q''(x)g(x) \oplus s'(x)$$

where,

$$s'(x) = s(x) \oplus e_r(x) \oplus c(x)$$

The syndrome $e_r(x)$ of an error word, can be retrieved by the summation on the coset polynomial and the old remainder, with the new remainder, thus,

$$e_r(x) = s'(x) \oplus s(x) \oplus c(x)$$

and in the presence of a detectable error, $e_r(x) \neq 0$.

The proposed detector can decode a coset code too, by introducing the coset polynomial's coeffi-

cients $c_i$, $(O \leqq i \leqq n\text{-}k\text{-}1)$ at the comparator (exclusive-or elements 13). This is always possible since a coset of the code can always be arranged such that it is formed by the addition of a polynomial $c(x)$ of a degree less than $(n\text{-}k\text{-}1)$ to the lowest order bits of the code word, i.e. not divisable by the generator polynomial $g(x)$. If the two remainders differ by the coset polynomial $c(x)$, then a valid code word has just been detected.

In the above there is thus described use of a decoder for a linear systematic code to provide a further function of a detection of a frame synchronisation pattern on a transmitted binary data stream. The decoder may be used for frame synchronisation acquisition and synchronisation error detection. The feature of the decoder that allows it to be used for this purpose, is the removal of the need to reset the decoder between code words and therefore the ability to continuously monitor the received binary data stream. This makes a fast and space efficient solution.

Frame synchronisation of a binary data stream is thus achieved using CRC encoded headers. A modified CRC detector is used to detect headers of frames on a binary data stream and the frame synchronisation at the receiver is performed without requiring further redundancy or synchronisation patterns.

The diagram depicts an arrangement suitable for those cyclic code structures where the generator polynomial $g(x)$ is a primitive polynomial of $x^n + 1$. In a shortened cyclic code, the length $n_s = n - i$ of the code word is shorter than the cyclic code for which the chosen $g(x)$ is a generator polynomial, by i bits. The shortened cyclic code is no longer truly cyclic, since it forms a sub-code of the cyclic code and all code words are preceded by i zeroed bits.

The specific hardware may be modified to operate on shortened cyclic code structures in the following way. The delay line must be reduced in length by i stages to length $n_s$, so that it reflects the length of the shortened code words. The code word formed by not resetting the decoders is now:-

$$i'(x) = x^{n_s} s(x) + i(x)$$
$$= x^{n_s} s(x) + q(x)g(x)$$
$$= (x^{n_s + i} + 1)s(x) + (x^i + 1)s(x) + q(x)g(x)$$
$$= [h(x)s(x) + q(x)]g(x) + (x^i + 1)s(x)$$
$$= q'(x)g(x) + s'(x)$$

i.e. since $g(x)$ is not a factor of $x^i$ for $i < n$, a new remainder is formed. If $i(x)$ is a valid code word, then the original remainder $s(x)$ is mathematically reproduced by autonomous clocking of the decoder a further i times, since there are conceptually i zeros following the code word. However the division by $g(x)$ is equivalent to a matrix multiplication of the contents of the decoder for each shift of the register. Thus i such shifts is equivalent to multiplying by this matrix raised to the power i, reproducing $s(x)$ in a single clock cycle. The non-zero elements of each column of this matrix can be realised in hardware as an exclusive-or of the corresponding stages in the decoder register, to produce each bit of the remainder. Thus this matrix can be realised as a linear operation on the contents of the first decoder indicated by dashed box 15 (or its inverse on the second decoder) just prior to the comparator.

The matrix operation would have to be performed in a single clock cycle to enable continuous monitoring of the data stream. However it could be pipelined by shortening the delay line by some amount, and inserting that amount of registers into the linear operation for storing partial results.

Although a serial implementation is referred to above, the method of non-resetting the CRC syndrome applies equally to a parallel implementation, of arbitrary parallel symbol width. Matrix operations would need to be performed on a symbol in one symbol lifetime. Other serial decoder implementations are also equally applicable as will be appreciated by those skilled in the art.

In the above, specific mention is made of a binary data stream. The invention is, however, not so restricted as will be appreciated by those skilled in the art. The header has a linear systematic code structure including information bits and check bits and in the general case the check bits (digits) are derived from a polynomial representative of the information bits (digits) of the header, which polynomial is required to have coefficients valid over a Galois field, by their polynomial division by a code generator polynomial whose coefficients are defined over a Galois field. In the general case, the "modulo-2" operations would be "modulo-Q" operations, where Q represents a valid coefficient of the code generator polynomial.

## Claims

1. A method of detecting frame synchronisation of a data stream, which frames are of fixed length or of a variable but determinable length indicated by a pattern or by information in the data stream, which frames include a fixed length header at a predetermined position in each frame, which header has a linear systematic code structure including information symbols and check symbols, which check symbols are derived from a polynomial representative of the information symbols of the header, which polynomial has coefficients valid over a Galois field, by their polynomial division by a code generator polynomial whose coefficients are defined over a Galois field, and wherein the check symbols are employed for frame synchronisation detection without compromising their responsible use for error detection in and correction of the header, characterised in that the method of detection comprises the steps of dividing an incoming data stream by the code generator polynomial, simulatneously dividing a preceding but delayed incoming data stream by the code generator polynomial, comparing any remainder of the first mentioned division with any remainder of the second mentioned simultaneous division, the presence of identical remainders indicating that the incoming data stream is a valid code word, and determining the occurrence of a succession of valid code words once every frame length for a predetermined number of frames, which occurrence indicates frame synchronisation.

2. A method as claimed in claim 1 characterised in that the division is carried out in a decoder (11, 12) including a shift register and wherein the shift register is not reset to all zero preceding all divisions other than in the initial condition.

3. A method as claimed in claim 1 characterised in that it is carried out by means of a parallel implementation of apparatus.

4. A method as claimed in claim 2 characterised in that the received binary data stream is continuously monitored at all bit positions.

5. A method as claimed in claim 1 or 2, characterised in that the true remainder of an errored code word is obtained by modulo-Q addition of the remainders of the first and subsequent divisions.

6. A method as claimed in claim 1 characterised in that a said data stream as transmitted from a transmitter to a receiver at which latter said frame synchronisation detection is performed, including the step of adding at the transmitter a non-zero coset polynomial to the code to be transmitted, which added polynomial results in a large error when a cyclic shift of a code word, rather than a code word itself, is decoded, dividing a first incoming code word by the code generator polynomial, dividing a subsequent incoming code word by the code generator polynomial and comparing any remainder of the first division with that of the subsequent division, a difference between the said remainders corresponding to the coset polynomial indicating detection of a valid code word, a succession of valid code words once every frame length for a predetermined number of frames indicating frame synchronisation.

7. A method as claimed in claim 1, characterised in that the header code structure is a pure or shortened cyclic code.

8. An apparatus for detecting frame synchronisation of a data stream, which frames are of fixed length or of a variable but determined length indicated by a pattern or by information in the data stream, which frames include a fixed length header at a predetermined position in each frame, which header has a linear systematic code structure including information digits and check digits, which check digits were derived from a polynomial representative of the information digits of the header, which polynomial has coefficients valid over a Galois field, by their polynomial division by a code generator polynomial whose coefficients are defined over a Galois field, the apparatus being characterised by means (12) whereby a first incoming code word is divided by the code generator polynomial, means (11) whereby a subsequent incoming code word is divided by the code generator polynomial, means (13,14) whereby any remainder of the first division is compared with any remainder of the subsequent division, the presence of a predetermined relationship therebetween indicating that the subsequent incoming code word is valid, and means for correlating and indicating frame synchronisation in response to receipt of a succession of valid code words once every predetermined frame length for a predetermined number of frames.

9. Apparatus as claimed in claim 8, characterised in that the predetermined relationship requires the remainders to be identical.

10. Apparatus as claimed in claim 8, and for use with a data stream transmitted from a transmitter to a receiver at which latter the said frame synchronisation detection is performed, and characterised by means at the transmitter for adding a non-zero coset polynomial to the code to be transmitted, which added polynomial results in large error when a cyclic shift of a code word, rather than the code word itself, is detected, and wherein the predetermined relationship required the remainders to differ by the coset polynomial.

11. Apparatus as claimed in any one of claims 8 to 10, characterised in that the first and subsequent code word dividing means comprises first decoder means (11) for performing the division of one incoming code word by the code generator polynomial and second decoder means (12) for performing the division of a delayed version of the preceding incoming code word by the code generator polynomial, delay line means (10) being coupled between inputs of the first and second decoders (11, 12).

12. Apparatus as claimed in any one of claims 8 to 10, and characterised by a parallel implementation.

13. Apparatus as claimed in claim 11 as appendent to claim 10, and characterised by means for applying the coset polynomial coefficients to the comparator means.

14. Apparatus as claimed in claim 11 or claim 13, characterised in that the decoders (11, 12) each include a respective shift register and employ linear feedback by exclusive-or operations, and wherein the comparison means include respective exclusive-or elements (13) and a multi-input logical nor function (14).

**Patentansprüche**

1. Verfahren zur Feststellung der Rahmensynchronisation eines Datenstroms, wobei die Rahmen eine feste Länge oder eine veränderliche, jedoch bestimmbare, durch ein Muster oder durch Informationen in dem Datenstrom angezeigte Länge aufweisen und einen eine feste Länge aufweisenden Kopf an einer vorgegebenen Position in jedem Rahmen einschließen, wobei der Kopf eine lineare systematische Codestruktur unter Einschluß von Informationssymbolen und Prüfsymbolen aufweist wobei die Prüfsymbole von einem die Informationssymbole des Kopfes darstellenden Polynom, das über ein Galois-Feld gültige Koeffizienten aufweist, durch eine Polynom-Division durch ein Codegenerator-Polynom abgeleitet werden, dessen Koeffizienten über ein Galois-Feld definiert sind, und wobei die Prüfsymbole für die Feststellung der Rahmensynchronisation ohne Beeinträchtigung ihrer zuverlässigen Verwendung für die Fehlererkennung in dem Kopf und die Korrektur des Kopfes verwendet werden,
dadurch gekennzichnet, daß das Verfahren zur Feststellung die Schritte der Division eines ankommenden Datenstroms durch das Codegenerator-Polynom, der gleichzeitigen Division eines vorhergehenden, jedoch verzögerten ankommenden Datenstroms durch das Codegenerator-Polynom, des Vergleichens irgendeines Restes der ersterwähnten Division mit irgendeinem Rest der zweitgenannten gleichzeitigen Division, wobei das Vorhandensein identischer Reste anzeigt, daß der ankommende Datenstrom ein gültiges Codewort ist, und der Bestimmung des Auftretens einer Folge von gültigen Codeworten einmal für jede Rahmenlänge für eine vorgegebene Anzahl von Rahmen umfaßt, wobei dieses Auftreten die Rahmensynchronisation anzeigt.

2. Verfahren nach Anspruch 1, dadurch gekennzeichnet, daß die Division in einem Decodierer (11, 12) durchgeführt wird, der ein Schieberegister einschließt, und daß das Schieberegister abgesehen von dem Anfangszustand vor allen Divisionen nicht auf einen Zustand mit lauter Nullen zurückgesetzt wird.

3. Verfahren nach Anspruch 1, dadurch gekennzeichnet, daß es mit Hilfe einer parallelen gerätemäßigen Ausführung einer Vorrichtung ausgeführt wird.

4. Verfahren nach Anspruch 2, dadurch gekennzeichnet, daß der empfangene Binärdatenstrom kontinuierlich an allen Bitpositionen überwacht wird.

5. Verfahren nach Anspruch 1 oder 2, dadurch gekennzeichnet, daß der wahre Rest eines fehlerbehafteten Codewortes durch eine Modulo-Q-Addition der Reste der ersten und nachfolgenden Divisionen gewonnen wird.

6. Verfahren nach Anspruch 1, dadurch gekennzeichnet, daß der genannte Datenstrom von einem Sender zu einem Empfänger übertragen wird, an dem die Rahmensynchronisations-Feststellung durchgeführt wird, und das Verfahren die Schritte der Addition eines von Null abweichenden Nebenklassen-Polynoms zu dem zu übertragenden Code an dem Sender, wobei das hinzuaddierte Polynom zu einem großen Fehler führt, wenn eine zyklische Verschiebung eines Codewortes anstelle eines Codewortes selbst decodiert wird, der Division eines ersten ankommenden Codewortes durch das Codegenerator-Polynom, der Division eines nachfolgend ankommenden Codewortes durch das Codegenerator-Polynom und des Vergleichens irgendeines Restes der ersten Division mit dem der zweiten Division umfaßt, wobei eine Differenz zwischen den Resten, die dem Nebenklassen-Polynom entspricht, die Feststellung eines gültigen Codewortes darstellt und eine Folge von gültigen Codeworten, jeweils einmal für jede Rahmenlänge für eine vorgegebene Anzahl von Rahmen, eine Rahmensynchronisation anzeigt.

7. Verfahren nach Anspruch 1, dadurch gekennzeichnet, daß die Kopf-Codestruktur ein reiner oder verkürzter zyklischer Code ist.

8. Vorrichtung zur Feststellung der Rahmensynchronisation eines Datenstroms, wobei die Rahmen eine feste Länge oder eine veränderliche, jedoch bestimmte, durch ein Muster oder durch Informationen in dem Datenstrom angezeigte Länge aufweisen und einen eine feste Länge aufweisenden Kopf an einer vorgegebenen Position in jedem Rahmen einschließen, wobei der Kopf eine lineare systematische Codestruktur unter Einschluß von Informationsziffern und Prüfziffern einschließt, von denen die Prüfziffern von einem die Informationsziffern des Kopfes darstellenden Polynom, das über ein Galois-Feld gültige Koeffizienten aufweist, durch polynom-Division durch ein Codegenerator-Polynom abgeleitet wurden, dessen Koeffizienten über ein Galois-Feld definiert sind, gekennzeichnet durch Einrichtungen (12), durch die ein erstes ankommendes Codewort durch das Codegenerator-Polynom dividiert wird, Einrichtungen (11), durch die ein nachfolgendes ankommendes Codewort durch das Codegenerator-Polynom dividiert wird, Einrichtungen (13, 14), durch die irgendein Rest der ersten Division mit irgendeinem Rest der nachfolgenden Division verglichen wird, wobei das Vorhandensein einer vorgegebenen Beziehung zwischen diesen anzeigt, daß das nachfolgend ankommende Codewort gültig ist, und Einrichtungen zur Korrelation und zur Anzeige der Rahmensynchronisation in Abhängigkeit von dem Empfang einer Folge von gültigen Codeworten einmal für jede vorgegebene Rahmenlänge für eine vorgegebene Anzahl von Rahmen.

9. Vorrichtung nach Anspruch 8,
dadurch gekennzeichnet, daß die vorgegebene Beziehung erfordert, daß die Reste identisch sind.

10. Vorrichtung nach Anspruch 8 zur Verwendung mit einem Datenstrom, der von einem Sender zu einem Empfänger übertragen wird, an dem die Feststellung der Rahmensynchronisation durchgeführt wird,
gekennzeichnet durch Einrichtungen an dem Sender zum Hinzuaddieren eines von Null abweichenden Nebenklassen-Polynoms zu dem zu übertragenden Code, wobei das hinzuaddierte Polynom zu einem großen Fehler führt, wenn eine zyklische Verschiebung eines Codewortes anstelle des Codewortes selbst festgestellt wird, und wobei die vorgegebene Beziehung erfordert, daß sich die Reste um das Nebenklassen-Polynom unterscheiden.

11. Vorrichtung nach einem der Ansprüche 8 bis 10, dadurch gekennzeichnet, daß die die ersten und nachfolgenden Codeworte dividierenden Einrichtungen erste Decodiereinrichtungen (11) zur Durchführung der Division eines ankommenden Codewortes durch das Codegenerator-Polynom und zweite Decodiereinrichtungen (12) zur Durchführung der Division einer verzögerten Version des vorhergehenden ankommenden Codewortes durch das Codegenerator-Polynom umfassen, und daß Verzögerungsleitungseinrichtungen (10) zwischen den Eingängen der ersten und zweiten Decodierer (11, 12) eingeschaltet sind.

12. Vorrichtung nach einem der Ansprüche 8 bis 10, gekennzeichnet durch eine parallele gerätemäßige Ausführung.

13. Vorrichtung nach Anspruch 11 unter Rückbeziehung auf Anspruch 10,
gekennzeichnet durch Einrichtungen zur Zuführung der Nebenklassen-Polynom-Koeffizienten an die Vergleichereinrichtungen.

14. Vorrichtung nach Anspruch 11 oder 13,
dadurch gekennzeichnet, daß die Decodierer (11, 12) jeweils ein jeweiliges Schieberegister einschließen und eine lineare Rückführung durch EXKLUSIV-ODER-Operationen verwenden, und daß die Vergleichereinrichtungen jeweilige EXKLUSIV-ODER-Elemente (13) und eine logische Mehrfacheingangs-NOR-Funktion 14 einschließen.

## Revendications

1. Procédé de détection de synchronisation de séquences d'un courant de données, les séquences ayant une longueur fixe ou une longueur variable mais qui peut être déterminée et qui est indiquée par un dessin ou par des informations du courant de données, les séquences comprenant un en-tête de longueur fixe en position prédéterminée dans chaque séquence, l'en-tête ayant une structure de code systématique linéaire contenant des symboles d'information et des symboles de vérification, les symboles de vérification étant dérivés d'un polynôme représentatif des symboles d'information de l'en-tête, ce polynôme ayant des coefficients valables sur un corps de Galois, par division polynomiale par un polynôme générateur de code dont les coefficients sont définis sur un corps de Galois, et dans lequel les symboles de vérification sont utilisés pour la détection de la synchronisation des séquences sans perturbation de leur utilisation correspondante pour la détection d'erreurs et la correction d'erreurs dans l'en-tête, caractérisé en ce que le procédé de détection comprend les étapes suivantes : la division du courant de données reçues par le polynôme générateur de code, la division simultanée d'un courant précédent de données reçues qui a été retardé par le polynôme générateur de code, la comparaison du reste éventuel de la première division au reste éventuel de la seconde division simultanée précitée, la présence de restes identiques indiquant que le courant de données reçues est un mot de code valable, et la détermination de l'apparition d'une succession de mots de code valables une fois par longueur de séquence pendant un nombre prédéterminé de séquences, cette apparition indiquant la synchronisation des séquences.

2. Procédé selon la revendication 1, caractérisé en ce que la division est effectuée dans un décodeur (11, 12) qui comprend un registre à décalage, et dans lequel le registre à décalage n'est pas entièrement remis à zéro avant toutes les divisions autrement qu'à l'état initial.

3. Procédé selon la revendication 1, caractérisé en ce qu'il a été exécuté par un appareil de réalisation de type parallèle.

4. Procédé selon la revendication 2, caractérisé en ce que le courant de données binaires reçues est constamment contrôlé à toutes les positions de bits.

5. Procédé selon la revendication 1 ou 2, caractérisé en ce que le reste véritable d'un mot de code ayant une erreur est obtenu par une addition modulo Q des restes de la première division et de divisions suivantes.

6. Procédé selon la revendication 1, caractérisé en ce qu'un courant de données est transmis d'un émetteur à un récepteur dans lequel la détection de la synchronisation des séquences est réalisée, le procédé comprenant les étapes suivantes : l'addition à l'émetteur d'un polynôme d'ensemble complémentaire non nul au code à transmettre. Le polynôme ajouté donnant une erreur importante lorsqu'un décalage cyclique d'un mot de code est décodé plutôt qu'un mot de code luimême, la division d'un premier mot de code reçu par le polynôme générateur de code, la division d'un mot de code reçu ultérieur par le polynôme générateur de code et la comparaison du reste de la première division a celui de la division suivante, une différence entre les restes correspondant au polynôme de l'ensemble complémentaire indiquant la détection d'un mot de code valable, une succession de mots de code valables une fois par longueur de séquence pendant un nombre prédéterminé de séquences indiquant une synchronisation des séquences.

7. Procédé selon la revendication 1, caractérisé en ce que la structure de code d'en-tête est un code cyclique pur ou raccourci.

8. Appareil de détection de la synchronisation de séquences d'un courant de données, les séquences ayant une longueur fixe ou une longueur variable mais déterminée qui est indiquée par un dessin ou par les informations du courant de données, les séquences comprenant un en-tête de longueur fixe ayant une position prédéterminée dans chaque séquence, l'en-tête ayant une structure de code systématique linéaire contenant des chiffres d'information et des chiffres de vérification, les chiffres de vérification étant dérivés d'un polynôme représentatif des chiffres d'information de l'en-tête, ce polynôme ayant des coefficients valables sur un corps de Galois, par division polynomiale par un polynôme générateur de code dont les coefficients sont définis sur un corps de Galois, l'appareil étant caractérisé par un dispositif (12) dans lequel un premier mot de code reçu est divisé par le polynôme générateur de code, un dispositif (11) par lequel un mot de code reçu suivant est divisé par le polynôme générateur de code, un dispositif (13, 14) par lequel le reste éventuel de la première division est comparé au reste éventuel de la division suivante, la présence d'une relation prédéterminée entre les restes indiquant que le mot de code reçu suivant est valable, et un dispositif destiné à corréler et indiquer la synchronisation de séquences à la suite de la réception d'une succession de mots de code valables une fois par longueur prédéterminée de séquence pendant un nombre prédéterminé de séquences.

9. Appareil selon la revendication 8, dans lequel la relation prédéterminée nécessite l'identité des restes.

10. Appareil selon la revendication 8, destiné à être utilisé avec un courant de données transmis d'un émetteur à un récepteur dans lequel la détection de synchronisation de séquences est réalisée, et caractérisé par un dispositif placé à l'émetteur et destiné à ajouter un polynôme d'ensemble complémentaire non nul au code à transmettre, ce polynôme ajouté provoquant une erreur importante lorsqu'un décalage cyclique d'un mot de code est détecté plutôt que le mot de code lui-même, et dans lequel la relation prédéterminée nécessite une différence entre les restes qui est égale au polynôme d'ensemble complémentaire.

11. Appareil selon l'une quelconque des revendications 8 à 10, caractérisé en ce que le dispositif de division du premier mot et du mot suivant de code comprend un premier dispositif décodeur (11) destiné à effectuer la division d'un mot de code reçu par le polynôme générateur de code et un second dispositif décodeur (12) destiné à effectuer la division d'une version retardée du mot de code reçu précédent par le polynôme générateur de code, un dispositif (10) à ligne à retard étant couplé entre les entrées du premier et du second décodeur (11, 12).

12. Appareil selon l'une quelconque des revendications 8 à 10, caractérisé par une réalisation parallèle.

13. Appareil selon la revendication 11 lorsqu'elle dépend de la revendication 10, caractérisé par un dispositif destiné à appliquer les coefficients du polynôme de l'ensemble complémentaire au dispositif comparateur.

14. Appareil selon la revendication 11 ou 13, caractérisé en ce que les décodeurs (11, 32) comportent chacun un registre à décalage respectif et utilisent une réaction négative linéaire par des opérations OU-exclusif, et le dispositif de comparaison comprend des éléments OU-exclusif respectifs (13) et une fonction logique NON-OU (14) à plusieurs entrées.

$\boxed{D}$ = delay element

$\oplus$ = exclusive or

$\widehat{V}$ = nor